# EUROPÄISCHE PATENTSCHRIFT

(11) **EP 0 824 053 B1**
(45) Veröffentlichungstag und Bekanntmachung des Hinweises auf die Patenterteilung: **03.04.2002**
(21) Anmeldenummer: 97112960.6
(22) Anmeldetag: 28.07.1997
(51) Int. Cl.: B24B 37/04, B24B 7/22, B24B 19/02, B24D 9/04

(54) **Gerät zum chemisch-mechanischen Polieren von Wafern**
Apparatus for chemical mechanical polishing of wafers
Appareil de polissage chimio-mécanique pour substrats

(30) Priorität: 14.08.1996 DE 19632809
(43) Veröffentlichungstag der Anmeldung: 18.02.1998
(73) Patentinhaber: Infineon Technologies AG, 81669 München (DE)
(72) Erfinder: Melzner, Hanno, 85716 Unterschleissheim (DE); Wendt, Hermann, Dr., 85630 Grasbrunn (DE)
(74) Vertreter: Kindermann, Peter, Dipl.-Ing.

(56) Entgegenhaltungen:
- EP-A- 0 724 932
- DE-A- 19 540 626
- US-A- 3 120 724
- US-A- 3 252 775
- US-A- 5 083 401
- PATENT ABSTRACTS OF JAPAN vol. 004, no. 099 (M-021), 16.Juli 1980 & JP 55 058984 A (TOKO DENKI KK), 2.Mai 1980,

## Beschreibung

Die vorliegende Erfindung betrifft ein Gerät zum chemisch-mechanischen Polieren von Wafern gemäß dem Oberbegriff des Anspruchs 1. Ein solches Gerät ist aus EP 0 724 932 A bekannt.

Das chemisch-mechanische Polieren (CMP) wurde erstmals im größeren Umfang bei der Herstellung von 16 Megabit-DRAMs eingesetzt und hat sich seitdem als ein Verfahren mit ständig wachsender Bedeutung erwiesen. So wird es beispielsweise zur Herstellung von Gräben, Grabenisolationen und von Metallbahnen sowie zur Planarisierung Intermetalldielektrika (IMD) eingesetzt. Ein Beispiel für eine Grabenisolation ist eine sogenannte flache Grabenisolation (STI; shallow trench isolation). Es hat sich gezeigt, daß bei allen oben genannten Anwendungsgebieten des chemisch-mechanischen Polierens Probleme insoweit auftreten, als häufig große Schwankungen des Abtrags über einen Wafer und von Wafer zu Wafer auftreten.

Ähnliche Probleme liegen auch bei der Herstellung von SOI-Wafern (SOI = Silicon on Insulator) mittels des Waferbonding-Verfahrens vor. Bei diesem Verfahren werden zwei Wafer, die aus Silizium bestehen und auf ihrer Oberfläche jeweils eine Siliziumdioxidschicht haben, über diese Siliziumdioxidschichten miteinander "verklebt", so daß insgesamt ein Halbleiterkörper entsteht, der in seiner Mitte eine aus den beiden Siliziumdioxidschichten bestehende Oxidschicht hat. Sodann wird einer der Wafer abgeschliffen, um schließlich eine dünne Siliziumschicht auf der Oxidschicht zu erhalten. Auch dieser Schleifprozeß ist an sich nicht ausreichend gleichmäßig, um eine hinreichend geringe Dickenschwankung der dünnen Siliziumschicht zu gewährleisten.

Zur Steigerung der Gleichmäßigkeit des Schleifprozesses wird neuerdings das sogenannte PACE-Verfahren eingesetzt (vergleiche "Microelectronic Engineering", Band 22, Seite 301, 1993). Bei diesem Verfahren wird zunächst die nach einem ersten groben Schleifschritt verbleibende Waferdicke als Profil über dem Wafer gemessen. Sodann wird ein relativ kleiner Plasmaätzer mit einem Durchmesser zwischen 3 und 30 mm, der von einem Computer mittels der gemessenen Schichtdickendaten gesteuert ist, über den Wafer geführt, damit überall auf dem Wafer die erwünschte endgültige Schichtdicke erzielt werden kann. Mit diesem Vorgehen lassen sich Dickenschwankungen erzielen, die unterhalb von 10 nm liegen.

Beim herkömmlichen CMP wird ein rotierender, scheibenförmiger Polierkörper mit Poliertuch oder "Pad" verwendet, um einen Wafer zu polieren, der im Bereich eines Radius des Polierkörpers in der gleichen Ebene wie dessen Oberfläche gelegen ist.

Auch das µ-chemisch-mechanische Polieren (µCMP) verwendet das oben genannte computergesteuerte Prinzip: Nach einem ersten herkömmlichen CMP-Schritt, bei dem rasch der größte Teil des zu entfernenden Materials abgetragen wird, wird die verbleibende Schichtdicke über dem Wafer vermessen. Hierzu gibt es in jedem Chip auf dem Wafer spezielle Meßfelder, die von einem automatischen Meßgerät angefahren werden. Ist eine Messung an allen Stellen über dem Wafer möglich, so können auch einfach bestimmte vorgegebene Punkte angesteuert werden. Die Meßfelder bzw. die vorgegebenen Punkte müssen dabei so dicht plaziert sein, daß die Schichtdicke zwischen den Meßfeldern bzw. Punkten im wesentlichen durch Interpolation zwischen den Meßfeldern bzw. Punkten gegeben ist. Sodann wird der Wafer mit einem speziellen µCMP-Poliergerät abgefahren, das momentan immer nur einen relativ kleinen Bereich des Wafers berührt.

Dabei sind mindestens drei Parameter geeignet, um den Polierabtrag entsprechend den Meßdaten für die Schichtdicke zu variieren: Drehzahl des Polierkörpers, Andruck des Polierkörpers auf den Wafer und Wanderungsgeschwindigkeit des Polierkörpers bezüglich der Oberfläche des Wafers.

Bei einem runden Wafer kann beispielsweise ein spiralförmiger Pfad des Polierkörpers verwendet werden. Dabei wird der Polierkörper in der Mitte des Wafers aufgesetzt, dann spiralförmig bis zum Rand des Wafers geführt, wobei sich die Pfade jeweils mehr oder weniger überlappen. Ein derartiger spiralförmiger Pfad läßt sich besonders leicht verwirklichen. Die Halteeinrichtung für den Wafer bzw. der Waferchuck rotiert langsam, während der Polierkörper in einer linearen Bewegung vom Mittelpunkt des Wafers nach außen geführt wird. Alternativ kann auch daran gedacht werden, den Wafer in linearen Streifen abzufahren. Auch ist es möglich, mehrere Polierkörper gleichzeitig an einem Wafer einzusetzen, um so die Bearbeitungszeit zu verkürzen. Dabei können bei jedem Polierkörper individuell Drehzahl und/oder Andruck und/oder Wanderungsgeschwindigkeit eingestellt werden. Möglicherweise könnte die Änderung der Drehzahl zur Variation des Abtrages dabei vorteilhaft sein.

Bisherige µCMP-Geräte verwenden Polierkörper, deren Achsen wie bei den seit längerem bekannten CMP-Geräten senkrecht zur Waferoberfläche verlaufen. Mit anderen Worten, alle bisherigen Geräte zum chemisch-mechanischen Polieren von Wafern haben Polierkörper, deren Drehachse senkrecht zur Waferoberfläche geführt ist. Zum Schleifen eines kleinen Teils der Waferoberfläche ist es nicht günstig, die bisherige Anordnung mit einer zur Waferoberfläche senkrechten Drehachse des Polierkörpers zu verwenden und dabei lediglich einen kleineren Polierkörper einzusetzen.

Denn während eines Polierprozesses liegt die Oberfläche eines Poliertuches oder Pads des Polierkörpers, das aus PU-Schaum (PU = Polyurethan) oder einem Textil-Material besteht, nicht frei, um mit Polierflüssigkeit bzw. "Slurry" besprenkelt zu werden.

Aus dem gleichen Grund ist es schwierig, das Poliertuch während des Polierens mit einem Schleifkörper speziell zum Aufrauhen zu behandeln, da dieses ebenfalls nur dann möglich ist, wenn die Oberfläche des Poliertuches zugänglich ist. Ein sogenanntes "Pad Conditioning" ist also schwierig durchzuführen.

Schließlich entsteht ein W-förmiges Abtragungsprofil, wenn eine rotierende Schleifscheibe mit zur Waferoberfläche senkrecht stehenden Achse über die Oberfläche des Wafers gezogen wird, wobei dieses Profil steile Flanken hat. Die W-Form ist darauf zurückzuführen, daß am Rand der Scheibe die Einwirkungszeit zwischen Poliertuch und Wafer nur gering ist, während in der Mitte der Scheibe die theoretische Drehzahl "0" vorliegt. Ein solches W-förmiges Abtragungsprofil ist wenig geeignet, um eine gleichmäßige Abtragung zu erreichen. Laufen beispielsweise zwei Gräben mit einem derartigen W-förmigen Abtragungsprofil parallel zueinander, so wird durch die steilen Flanken jeder Fehler in der relativen Lage der Gräben zueinander zu starken Abtragungsschwankungen im Überlappungsbereich führen.

Aus der Druckschrift EP 0 724 932 A ist ein Gerät zum chemisch-mechanischen Polieren von Wafern bekannt, mit einer mit einem Polierkörper versehenen, umlaufenden Scheibe, einer Zufuhreinrichtung für eine Polierflussigkeit, und einer Halteeinrichtung für den Wafer, wobei die Achse der Scheibe parallel zu der Oberfläche des Wafers verläuft. Auf diese Weise kann eine sogenannte Prozess-Transformationsschicht, welche Mikrorisse und Versetzungen aufweist, bis auf eine Dicke von ca. 0.1 µm verringert werden. Darüber hinaus können durch das Polieren verursachte Ungleichmäßigkeiten bzw. Welligkeiten bis auf eine Amplitude von ca. 0.3 µm reduziert werden. Eine vollständige Beseitigung derartiger Wellen ist jedoch mit diesem Gerät nicht möglich.

Der Erfindung liegt daher die Aufgabe zugrunde, ein Gerät zum chemisch-mechanischen Polieren von Wafern zu schaffen, mit dem Ungleichmäßigkeiten bzw. Welligkeiten hochgenau ausgeglichen werden können.

Diese Aufgabe wird erfindungsgemäß durch die Merkmale des Patentanspruchs 1 gelöst.

Das Profil des Abtragungsgrabens läßt sich auf diese Weise in weiten Grenzen sehr genau einstellen, wobei beispielsweise Abtragungsgräben mit dreieckförmigem Profil oder trapezförmigem Profil ohne weiteres zu erzielen sind.

Insbesondere zur Realisierung eines Grabens mit dreieckförmigem Querschnitt kann ein Polierkörper aus zwei Polierkörper-Teilen mit jeweils parallelogrammförmigen Umriß, bei dem die Senkrechte auf einer Schmalseite einen gegenüberliegenden Eckpunkt schneidet, auf die Randfläche der Scheibe aufge bracht werden. Ein solcher Abtragungsgraben mit dreieckförmigem Profil ist besonders wünschenswert, da bei Überlappung von zwei solchen Abtragungsgräben ein theoretisch vollkommen gleichmäßiger Abtrag erzielt wird, wenn der Abstand der beiden Gräben eine halbe Grabenbreite beträgt. Dieses dreieckförmige Profil entsteht, da die Abtragung in guter Näherung proportional zu der Zeit ist, während der ein bestimmter Punkt des Polierkörpers in Berührung mit dem Wafer ist.

Ferner kann zur Realisierung eines Grabens mit trapezförmigem Querschnitt ein Polierkörper aus zwei Polierkörper-Teilen mit jeweils parallelogrammförmigem Umriß, bei dem die Senkrechte auf einer Schmalseite die gegenüberliegende Schmalseite schneidet, auf die Randfläche der Scheibe aufgebracht werden.

Selbstverständlich lassen sich auch kompliziertere Profile als dreieckförmige oder trapezförmige Profile erzielen.

Der Durchmesser der Scheibe kann etwa 10 cm betragen, während die Randbreite der Scheibe, also die Höhe des "Zylinders" etwa 1 cm mißt.

Bei dem erfindungsgemäßen Gerät verläuft die Achse des Polierkörpers ebenso parallel zur Oberfläche des Wafers. Der Polierkörper ist dabei auf den Rand bzw. die "Zylindermantelfläche" der Scheibe aufgebracht, so daß der Polierkörper die Oberfläche des Wafers an einer Stelle des Umfanges der Scheibe berührt. Der Vorschub zwischen Scheibe und Wafer kann dabei beispielsweise senkrecht zur Achse des Polierkörpers eingestellt werden.

Durch eine derartige Gestaltung des Gerätes ergeben sich die weiteren Vorteile:

Das Poliertuch liegt während eines Polierprozesses bis auf die Berührungsstelle mit der Oberfläche des Wafers offen und kann kontinuierlich mit Polierflüssigkeit benetzt und behandelt werden.

Bei dem erfindungsgemäßen Gerät erfolgt die Bewegung des Poliertuches relativ zum Wafer immer in einer Richtung. Bei den herkömmlichen Geräten rotiert der Wafer, so daß im Mittel alle Richtungen etwa gleich häufig oft vorkommen. Dennoch ist bei dem erfindungsgemäßen Gerät die Bewegung zwischen Poliertuch und Wafer in nur einer Richtung unkritisch, da der Hauptteil einer abzutragenden Schicht zuvor auf herkömmliche Weise abgetragen werden kann. Auch ist es möglich, den Wafer mehrmals in verschiedenen Orientierungen zu bearbeiten.

Weiterhin bietet die feste Schleifrichtung einen gewissen Vorteil bei der automatischen Detektion von durch das chemisch-mechanische Polieren induzierten Kratzern, die immer wieder durch Verunreinigungen des Poliertuches vorkommen. Da diese Kratzer nämlich in einer bestimmten Richtung verlaufen, sind sie leicht automatisch dem entsprechenden Prozeß zuzuordnen.

Neben der genauen Steuerbarkeit der Abtragung hat das erfindungsgemäße Gerät auch den Vorteil eines sehr kompakten Aufbaues: Gegenüber herkömmlichen Geräten mit einer Standfläche von mehreren Quadratmetern, ist das erfindungsgemäße Gerät in seiner Größe vergleichbar mit einer verkürzten Tischdrehbank.

So kann eine als Halteeinrichtung dienende Wafer-Aufspanneinrichtung federnd auf einer Lagereinrichtung gelagert sein, die aus einem Quersupport und einem Längssupport besteht.

Der prinzipielle Aufbau des erfindungsgemäßen Gerätes ist so mit dem einer Drehbank mit horizontaler Spindel, Quersupport und Längssupport vergleichbar. Quersupport und Längssupport haben jeweils Motorantriebe. Außerdem ist eine elektronische Drehzahlsteuerung für die Scheibe vorgesehen.

Infolge des relativ einfachen Aufbaues und der kleineren benötigten Standfläche kann sogar daran gedacht werden, auf einen ersten Bearbeitungsschritt mit einem herkömmlichen Polieren ganz zu verzichten und statt dessen das erfindungsgemäße Gerät zweimal zur Abtragung bei der gleichen Scheibe einzusetzen, wobei in einem ersten Schritt die Drehzahl relativ grob gesteuert wird und in einem zweiten Schritt die Drehzahl dann mit feiner Steuerung eingestellt wird.

Ein Wechsel des Poliertuches kann auf einfache Weise durch Austauschen der Scheibe vorgenommen werden. Die Scheiben können dann, ohne den Durchsatz des Gerätes zu vermindern, mit neuen Poliertüchern belegt werden.

Wie bei den herkömmlichen Geräten kann der Polierkörper aus Polyurethan-Schaum oder Textil-Material hergestellt sein.

Nachfolgend wird die Erfindung anhand der Zeichnungen näher erläutert. Es zeigen
- Fig. 1: eine schematische Darstellung des erfindungsgemäßen Gerätes in einer Seitenansicht;
- Fig. 2: eine Darstellung einer Scheibe mit einem darauf aufgetragenen Polierkörper zur Erzielung eines Abtragungsgrabens mit dreieckförmigem Profil;
- Fig. 3: eine Abwicklung eines Polierkörpers zur Erzielung eines Abtragungsgrabens mit dreieckförmigem Profil;
- Fig. 4: eine Abwicklung eines Polierkörpers zur Erzielung eines Abtragungsgrabens mit trapezförmigem Profil, und
- Fig. 5: ein Diagramm zur Erläuterung des Ausgleichs vorliegender Dickenschwankungen durch meßwertgesteuerten Abtrag.

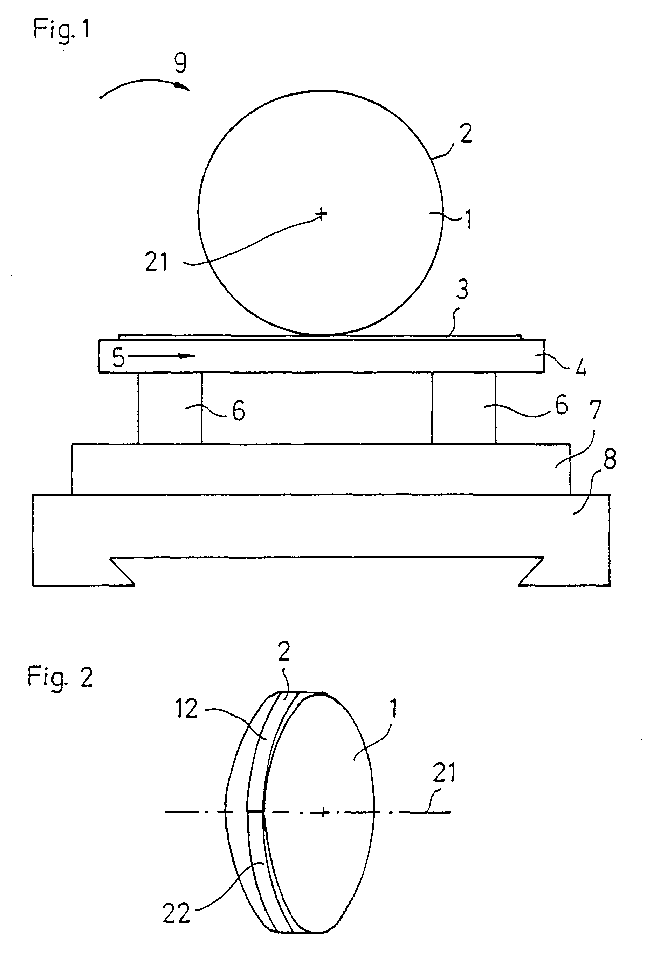

Fig. 1 zeigt eine Schleif- bzw. Polierscheibe 1, auf deren Rand als Polierkörper ein Poliertuch 2 aufgebracht ist. Dieses Poliertuch 2 kann aus Polyurethan-Schaum oder aus Textil-Material bestehen. Mit dem Poliertuch 2 wird ein Wafer 3 behandelt, um in diesen einen Abtragungsgraben einzubringen. Der Wafer 3 ist mittels einer nicht gezeigten Halteeinrichtung auf einem Tisch 4 befestigt, welcher einem Vorschub in der Richtung eines Pfeiles 5 unterliegt. Der Tisch 4 weist eine Einrichtung 6 zur Parallelführung mit Federung und Höhenverstellung auf. Der Tisch 4 mit der Einrichtung 6 ist auf einem Quersupport 7 und einem Längssupport 8 gelagert. Die Achse 21 der Scheibe 1 verläuft parallel zur Oberfläche des Wafers 3 und nicht - wie bisher üblich - senkrecht hierzu.

Während der Bearbeitung der Oberfläche des Wafers 3 muß das Poliertuch 2 mit Polierflüssigkeit besprenkelt und behandelt bzw. aufgerauht werden. Wie aus der Fig. 1 sofort ersichtlich ist, ist die Oberfläche des Poliertuches 2 mit Ausnahme der Berührungsstelle zu der Oberfläche des Wafers 3 frei zugänglich, so daß die Polierflüssigkeit ohne weiteres zugeführt und auch das Poliertuch behandelt bzw. aufgerauht werden kann. Dies ist schematisch durch einen Pfeil 9 angedeutet.

Fig. 2 zeigt eine perspektivische Darstellung der Scheibe 1, auf deren Rand bzw. zylinderförmige Mantelfläche der Polierkörper in der Form eines Poliertuches 2 aufgetragen ist. Die Scheibe 1 hat einen Durchmesser von etwa 10 cm und eine Höhe bzw. Breite von etwa 1 cm.

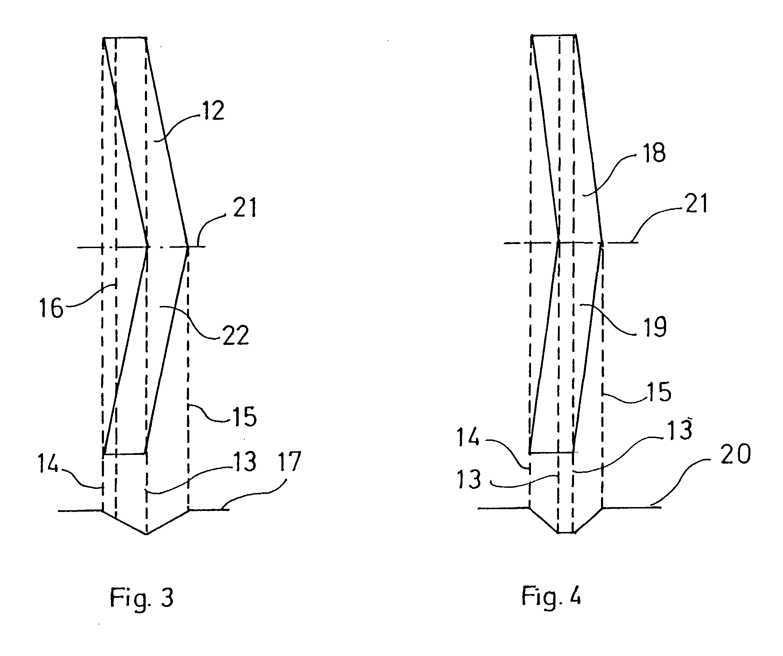

Die in der Fig. 2 gezeigte Scheibe ist zur Realisierung eines Abtragungsgrabens mit dreieckförmigem Profil geeignet. Dies soll anhand der Fig. 3 näher erläutert werden.

Wie bereits eingangs erläutert wurde, ist die Abtragung in guter Näherung proportional zu der Zeit, während der ein bestimmter Punkt des Abtragungstuches 2 mit der Oberfläche des Wafers 3 in Berührung steht. Fig. 3 zeigt nun in Draufsicht zwei parallelogrammförmige Abtragungstücher 12 und 22 in Draufsicht, bevor diese auf den Rand der Scheibe 1 aufgetragen werden, wie dies in Fig. 2 dargestellt ist. Eine Strichlinie 13 verläuft durch jeweils zwei gegenüberliegende Eckpunkte der beiden Parallelogramme und so vollständig innerhalb beiden Parallelogrammen. Das heißt, im Bereich dieser Strichlinie sind die Poliertücher entsprechend den Parallelogrammen 12 und 22 ständig in Berührung mit der Oberfläche des Wafers. Mit anderen Worten, die größte Abtragung wird an dieser Stelle erzielt. Im Bereich von Strichlinien 14 und 15 tritt nur eine punktuelle Berührung zwischen dem Poliertuch 2 und der Oberfläche des Wafers 3 auf. Hier ist also die Abtragung minimal. Eine Strichlinie 16 steht für eine relativ geringfügige Abtragung, da sie nur kurz durch die Parallelogramme 12 und 22 verläuft.

Insgesamt wird also mit einem entsprechend dem Ausführungsbeispiel von Fig. 3 gestalteten Polierkörper ein Abtragungsgraben mit dreieckförmigem Profil 17 erreicht.

Fig. 4 gibt ein Beispiel für die Belegung des Randes der Scheibe 1 mit dem Poliertuch 2 an, das so aus zwei parallelogrammförmigen Teilen 18, 19 gestaltet ist, daß ein Profil 20 mit trapezförmigem Querschnitt erzielt wird. Die beiden Strichlinien 13 geben den Rand des Bereiches mit maximaler Abtragung an, während die Strichlinien 14, 15 den Beginn der Abtragung durch punktuelle Berührung zwischen dem Polierkörper und dem Wafer 3 bedeuten.

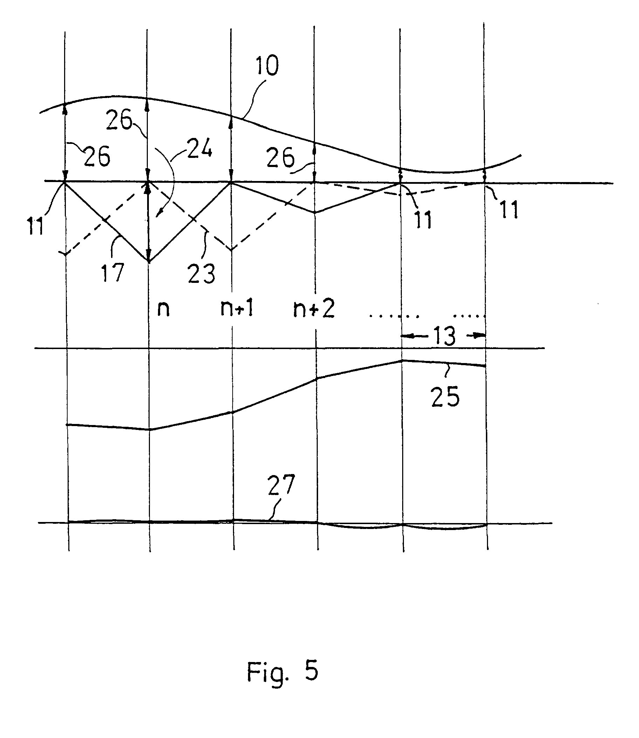

Fig. 5 veranschaulicht den Ausgleich vorhandener und gemessener Dickenschwankungen mit Hilfe des erfindungsgemäßen Gerätes. Ein vorgefundenes Dickenprofil 10 läßt sich dann ausgleichen, wenn die Dicke zwischen zwei Meßpunkten 11 im Abstand einer halben Grabenbreite 13 im wesentlichen durch eine lineare Interpolation zwischen diesen Meßpunkten gegeben ist und an den Meßpunkten Dickenmessungen vorliegen. In Fig. 5 sind die Abträge für Gräben n, n+2,... durch eine Vollkurve 17 und für Gräben n+1, n+3,... durch eine Strichkurve 23 veranschaulicht. Die Größe des Abtrages in der Grabenmitte ist dabei durch die jeweiligen Meßwerte 26 in den Meßpunkten 11 gesteuert, wie dies durch einen Pfeil 24 angedeutet ist. Der Gesamtabtrag ergibt sich aus der Summe der Abträge entsprechend den Kurven 17 und 23 und ist durch eine Kurve 25 angedeutet. Wird dieser Gesamtabtrag (Kurve 25) vom vorgefundenen Dickenprofil 10 abgezogen, so wird ein Endprofil 27 mit praktisch ebener Oberfläche erhalten.

## Patentansprüche

1. Gerät zum chemisch-mechanischen Polieren von Wafern (3), mit
einer mit einem Polierkörper (2) versehenen, umlaufenden Scheibe (1),
einer Zufuhreinrichtung (9) für eine Polierflüssigkeit, und
einer Halteeinrichtung (4) für den Wafer (3), wobei
die Achse (21) der Scheibe (1) parallel zu der Oberfläche des Wafers (3) verläuft,
**dadurch gekennzeichnet,**
**daß** der Polierkörper (2) einen im wesentlichen parallelogrammförmigen Umriss zu einer zylinderförmigen Randfläche der Scheibe (1) derart aufweist, daß in den Wafer (3) ein Graben mit definiertem Querschnitt (17, 20) einbringbar ist.

2. Gerät nach Anspruch 1,
**dadurch gekennzeichnet,**
**daß** eine als Halteeinrichtung dienende Wafer-Aufspanneinrichtung federnd auf einer Lagereinrichtung (6, 7, 8) gelagert ist.

3. Gerät nach Anspruch 2,
**dadurch gekennzeichnet,**
**daß** die Lagereinrichtung aus einem Quersupport (7) und einem Längssupport (8) besteht.

4. Gerät nach einem der Ansprüche 1 bis 3,
**dadurch gekennzeichnet,**
**daß** die Zufuhreinrichtung (9) für die Polierflüssigkeit den Polierkörper (2) ständig mit der Polierflüssigkeit zu versorgen vermag.

5. Gerät nach einem der Ansprüche 1 bis 4,
**dadurch gekennzeichnet,**
**daß** zur Realisierung eines Grabens mit dreieckförmigem Querschnitt (17) der Polierkörper (2) aus zwei Polierkörper-Teilen (12, 22) besteht, bei dem die Senkrechte auf einer Schmalseite einen gegenüberliegenden Eckpunkt schneidet.

6. Gerät nach einem der Ansprüche 1 bis 5,
**dadurch gekennzeichnet,**
**daß** zur Realisierung eines Grabens mit trapezförmigem Querschnitt (20) ein Polierkörper (2) aus zwei Polierkörper-Teilen (18, 19) besteht, bei dem die Senkrechte auf einer Schmalseite die gegenüberliegende Schmalseite schneidet.

7. Gerät nach einem der Ansprüche 1 bis 6,
**dadurch gekennzeichnet,**
**daß** der Durchmesser der Scheibe (1) etwa 10 cm und die Randbreite der Scheibe (1) etwa 1 cm betragen.

8. Gerät nach einem der Ansprüche 1 bis 7,
**dadurch gekennzeichnet,**
**daß** der Polierkörper (2) aus Polyurethan-Schaum oder Textil-Material besteht.

## Claims

1. Appliance for the chemicomechanical polishing of wafers (3),
having a rotating disc (1) provided with a polishing body (2),
having a supply means (9) for a polishing fluid and
having a holding means (4) for the wafer (3),
the axis (21) of the disc (1) running parallel to the surface of the wafer (3),
**characterized in that**
the polishing body (2) has a substantially paralellogram-shaped contour to a cylindrical edge face of the disc (1) in such a way that a trench of specific cross section (17, 20) can be made in the wafer (3).

2. Appliance according to Claim 1, **characterized in that** a wafer chucking means serving as a holding means is mounted resiliently on a bearing means (6, 7, 8).

3. Appliance according to Claim 2, **characterized in that** the bearing means is composed of a transverse support (7) and of a longitudinal support (8).

4. Appliance according to one of Claims 1 to 3, **characterized in that** the supply means (9) for the polishing fluid can supply the polishing body (2) constantly with the polishing fluid.

5. Appliance according to one of Claims 1 to 4, **characterized in that**, in order to produce a trench of triangular cross section (17), the polishing body (2) is composed of two polishing body parts (12, 22), in which the perpendicular to a narrow side intersects an opposite corner point.

6. Appliance according to one of Claims 1 to 5, **characterized in that**, in order to produce a trench of trapezoidal cross section (20), a polishing body (2) is composed of two polishing body parts (18, 19), in which the perpendicular to one narrow side intersects the opposite narrow side.

7. Appliance according to one of Claims 1 to 6, **characterized in that** the diameter of the disc (1) amounts to about 10 cm and the edge width of the disc (1) to about 1 cm.

8. Appliance according to one of Claims 1 to 7, **characterized in that** the polishing body (2) is composed of polyurethane foam or textile material.

## Revendications

1. Appareil pour le polissage chimio-mécanique de substrats (3), comportant
un disque rotatif (1) muni d'un corps de polissage (2),
un dispositif d'alimentation (9) pour un liquide de polissage, et
un dispositif de fixation (4) pour le substrat (3),
l'axe (21) du disque (1) s'étendant parallèlement à la surface du substrat (3),
**caractérisé par le fait que** le corps de polissage (2) a un contour sensiblement en forme de parallélogramme par rapport à une surface de bord cylindrique du disque (1) de telle sorte qu'un sillon de section transversale définie (17, 20) peut être pratiqué dans le substrat (3).

2. Appareil selon la revendication 1,
**caractérisé par le fait qu'**un dispositif de serrage de substrat servant de dispositif de fixation est logé de façon élastique sur un dispositif de montage (6, 7, 8).

3. Appareil selon la revendication 2,
**caractérisé par le fait que** le dispositif de montage est constitué d'un support transversal (7) et d'un support longitudinal (8).

4. Appareil selon l'une des revendications 1 à 3,
**caractérisé par le fait que** le dispositif d'alimentation (9) pour le liquide de polissage peut alimenter constamment le corps de polissage (2) en liquide de polissage.

5. Appareil selon l'une des revendications 1 à 4,
**caractérisé par le fait que**, pour la réalisation d'un sillon à section transversale triangulaire (17), le corps de polissage (2) est constitué de deux parties de corps de polissage (12, 22) dans lesquelles les perpendiculaires à un petit côté passent par un sommet opposé.

6. Appareil selon l'une des revendications 1 à 5,
**caractérisé par le fait que**, pour la réalisation d'un sillon à section transversale trapézoïdale (20), un corps de polissage (2) est constitué de deux parties de corps de polissage (18, 19) dans lesquelles les perpendiculaires à un petit côté coupent le petit côté opposé.

7. Appareil selon l'une des revendications 1 à 6,
**caractérisé par le fait que** le diamètre du disque (1) vaut 10 cm environ et la largeur de bord du disque (1) vaut 1 cm environ.

8. Appareil selon l'une des revendications 1 à 7,
**caractérisé par le fait que** le corps de polissage (2) est en une mousse polyuréthane ou en un matériau textile.
